# EUROPÄISCHE PATENTSCHRIFT

(11) **EP 0 662 661 B1**
(45) Veröffentlichungstag und Bekanntmachung des Hinweises auf die Patenterteilung: **17.03.1999**
(21) Anmeldenummer: 94120874.6
(22) Anmeldetag: 28.12.1994
(51) Int. Cl.: G01R 31/3167, G06F 11/22

(54) **Schaltungsanordnung zum Aufbereiten analoger Signale für ein Boundary-Scan-Prüfverfahren**
Circuit device to prepare analog signals for a boundary scan test procedure
Circuit pour préparer des signaux analogiques pour un procédé de test de type boundary scan

(30) Priorität: 05.01.1994 DE 4400194
(43) Veröffentlichungstag der Anmeldung: 12.07.1995
(73) Patentinhaber: SIEMENS AKTIENGESELLSCHAFT, 80333 München (DE)
(72) Erfinder: Wiemers, Thomas, D-42327 Wuppertal (DE); Van den Boom, Johannes, D-40239 Düsseldorf (DE)

(56) Entgegenhaltungen:
- EP-A- 0 239 929
- IBM TECHNICAL DISCLOSURE BULLETIN., Bd.27, Nr.2, Juli 1984, NEW YORK US Seite 1046 W. V. MYERS 'Latching analog comparator circuit'

## Beschreibung

Die Erfindung betrifft eine Schaltungsanordnung zum Aufbereiten analoger Signale für ein Boundary-Scan-Prüfverfahren.

Die Funktionsweise eines Boundary-Scan ist z. B. in Elrad, 3-92 auf Seite 36 - 41 näher beschrieben. Der Boundary-Scan hat sich als Standardsystem zum Testen integrierter Schaltungen sowie komplexer Systeme entwickelt.

Nachteil des Boundary-Scan ist, daß er nur bei digitalen Systemen eingesetzt werden kann. Analoge Signale können vom Boundary-Scan-Test nicht erfaßt werden.

Jedoch wird auch bei digitalen Systemen in zunehmendem Maße das Testen von analogen Signalen, die z. B. von AD-Wandlern, DA-Wandlern oder Referenzspannungen erzeugt werden, notwendig.

Aus der EP-A 0 239 929 ist eine integrierte Schnittstellenschaltung für Analog-Digital-Schaltungen bekannte geworden. Dabei wird zu Test- und Simulationszwecken zwischen extern zugänglichen analogen Schaltungen und einer internen digitalen Schaltung eine Schnittstelle und ein Abtastsignalweg geschaltet. In einer Ausführung ermöglicht ein Signalweg den Zugriff zu besonderen Teilen der Schaltungsanordnung zu Testzwecken. Zur Aufbereitung analoger Signale kommen Schmitt-Trigger zum Einsatz.

Aufgabe der vorliegenden Erfindung ist es, eine einfache Schaltungsanordnung anzugeben, die es erlaubt, analoge Signale für ein Boundary-Scan-Prüfverfahren aufzubereiten.

Diese Aufgabe wird durch den kennzeichnenden Teil des Anspruchs 1 gelöst.

Die Erfindung wird nachfolgend anhand von einer Figur näher erläutert.

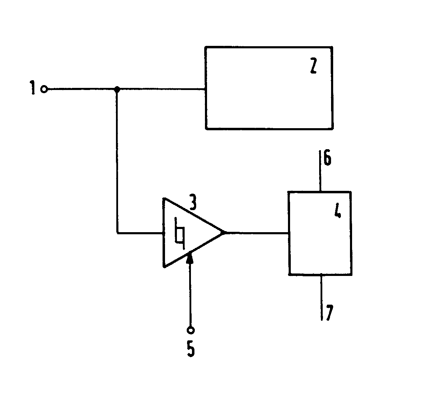

In der Figur ist mit 1 ein extern zugänglicher Eingangs- bzw. Ausgangsanschluß einer integrierten Schaltung oder ein interner Anschluß bezeichnet. Dieser ist mit einer Analogschaltung 2 verbunden. Ein Schmitt-Trigger 3 ist vorgesehen, dessen Eingang mit der Anschlußklemme 1 verbunden ist. Der Schmitt-Trigger ist steuerbar ausgeführt, so daß er über einen Steueranschluß und eine zugehörige Anschlußklemme 5 aktiviert bzw. deaktiviert werden kann. Der Ausgang des Schmitt-Triggers 3 ist mit einer Standard-Boundary-Scan-Zelle 4 verschaltet. Diese weist einen Boundary-Scan-Eingang 7 und einen Boundary-Scan-Ausgang 6 auf.

Es sei angenommen, daß ein analoges Signal von oder zur Klemme 1 geführt wird. Um dieses analoge Signal zu beobachten, wird dieses durch den Schmitt-Trigger 3 in ein einfaches logisches Signal gewandelt. Hierzu wird der Schmitt-Trigger 3 über die Anschlußklemme 5 aktiviert. Das am Ausgang des Schmitt-Trigger 3 abgreifbare digitale Signal kann nun durch eine Standard-Boundary-Zelle 4 in den Boundary-Scan-Test eingebunden werden.

Während des Normalbetriebs des Bausteins kann der Schmitt-Trigger über die Anschlußklemme 5 deaktiviert werden, so daß keine Querströme im Schmitt-Trigger 3 entstehen. Durch den an die Boundary-Scan-Zelle 4 angebundenen Schmitt-Trigger 3 kann der Schaltpunkt bestimmt werden.

Durch die erfindungsgemäße Anordnung können zwar nicht die Korrektheit der analogen Signale überprüft werden, jedoch kann, was in vielen Fällen sehr wichtig ist, ein Verbindungstest der signalführenden Analogleitung erfolgen und darüber hinaus geprüft werden, ob z. B. eine Referenzspannung eingeschaltet ist oder nicht.

## Patentansprüche

1. Schaltungsanordnung zum Aufbereiten analoger Signale für ein Boundary-Scan-Prüfverfahren, wobei das analoge Signal einem Schmitt-Trigger (3) zugeführt wird,
**dadurch gekennzeichnet,** daß
- das analoge Signal an einem extern zugänglichen Eingangs- bzw. Ausgangsanschluß (1) abgegriffen wird,
- der Ausgang des Schmitt-Triggers (3) mit einer Boundary-Zellen-Eingangsstruktur (4, 6, 7) verbunden ist, und
- der Schmitt-Trigger (3) abschaltbar ist.

## Claims

1. Circuit arrangement for conditioning analog signals for a boundary scan test procedure, the analog signal being fed to a Schmitt trigger (3),
characterized in that
- the analog signal is picked off at an externally accessible input or output terminal (1),
- the output of the Schmitt trigger (3) is connected to a boundary cell input structure (4, 6, 7), and
- the Schmitt trigger (3) can be switched off.

## Revendications

1. Montage pour mettre à disposition des signaux analogiques pour un procédé de test Boundary-Scan, le signal analogique étant envoyé à un trigger (3) de Schmitt, caractérisé en ce que
- le signal analogique est prélevé à un raccordement (1) d'entrée et de sortie accessible de manière externe,
- la sortie du trigger (3) de Schmitt est reliée à une structure (4, 6, 7) d'entrée à cellule Boundary, et
- le trigger (3) de Schmitt peut être déconnecté.
